# EUROPEAN PATENT SPECIFICATION

(11) **EP 3 267 447 B1**
(45) Date of publication and mention of the grant of the patent: **08.04.2020**
(21) Application number: 17179570.1
(22) Date of filing: 04.07.2017
(51) Int. Cl.: H01H 1/62, H01R 13/00, H01R 25/16, H02B 11/04, H02B 1/56, H02G 5/10, H05K 7/20

(54) **CONTACT DEVICE FOR HIGH-CURRENT TRANSFER**
KONTAKTEINRICHTUNG ZUR HOCHSTROMÜBERTRAGUNG
DISPOSITIF DE CONTACT DE TRANSFERT DE COURANT FORT

(30) Priority: 05.07.2016 DE 102016112279
(43) Date of publication of application: 10.01.2018
(73) Proprietor: TE Connectivity Germany GmbH, 64625 Bensheim (DE)
(72) Inventor: SCHWAN, Ralf, 64683 Einhausen (DE)
(74) Representative: Patentanwaltskanzlei WILHELM & BECK

(56) References cited:
- WO-A1-2012/161930
- WO-A1-2013/139666
- US-A1- 2013 319 024

## Description

The invention relates to a contact device according to Claim 1.

An arrangement comprising a contact device and a bus bar is known, wherein the contact device has a contact element and a contact housing. The contact element is electrically connected to the bus bar. When transferring high currents to the bus bar via the contact element, the contact element heats up considerably. The heating limits the current which can be introduced into the bus bar via the contact element.

WO 2012/161930 A1, WO 2013/139666 A1 and US2013/0319024 A1 teach a cooling apparatus for cooling a switchgear is provided. The switchgear has one or more primary contacts supported by a bushing and constructed and arranged to connect to a terminal of a circuit breaker. The cooling apparatus includes at least one evaporator associated with each primary contact, a condenser apparatus located at a higher elevation than the at least one evaporator, fluid conduit structure connecting the at least one evaporator with the condenser apparatus, and electrically insulating working fluid in at least one evaporator so as to be heated to a vapor state, with the fluid conduit structure being constructed and arranged to transfer the vapor to the condenser apparatus and to passively return condensed working fluid back to the at least one evaporator.

The problem of the invention is to provide an improved contact device.

This problem is solved by means of a contact device according to Claim 1. Advantageous embodiments are specified in the dependent claims.

According to the invention, it has been recognised that an improved contact device for transferring high current can be provided in that the contact device comprises a contact element and a cooling unit, wherein the cooling unit comprises a heat sink, a heat transfer medium, a first heat exchanger section and a second heat exchanger section, wherein the first heat exchanger section is connected to the second heat exchanger section in a fluidic manner. The heat sink is arranged at a distance from the contact element. The heat sink is connected to the second heat exchanger section. The first heat exchanger section is arranged in the contact element, wherein the heat transfer medium circulates between the first heat exchanger section and the second heat exchanger section, wherein the heat sink is electrically insulated from the contact element. The contact element extends in the longitudinal direction. The contact element has, on an outer peripheral surface, a contact surface for electrical contacting. Furthermore, the contact element has a recess which extends, at least in sections, in the longitudinal direction. The first heat exchanger section is arranged in the recess. A first joining section is supplied on a longitudinal end of the contact element. Furthermore, the contact device comprises a connection piece. The connection piece comprises a tubular section and a second joining section which is connected to the tubular section. The tubular section is arranged in the recess. The second joining section is connected to the first joining section in a fluid-tight manner. The tubular section is arranged running centrally in the recess. In this way, a uniform carry-off of heat from the contact element can be ensured. The connection piece has an outlet. The tubular section has an outer peripheral surface. The recess and the outer peripheral surface of the tubular section delimit the first heat exchanger section. The first heat exchanger section is connected to the outlet of the connection piece in a fluidic manner.

This design has the advantage that a particularly large amount of heat can be carried off from the contact element when the contact device is in operation and in result a high heat input can be carried off from the contact element and thus higher currents can be conducted via the contact element with the same structural design of the contact element. Furthermore this design has the advantage that the contact element is configured particularly compactly and can be electrically connected to further contact devices which have been used before now. Also a discharge of the heat transfer medium from the recess is avoided.

In a further embodiment, the first joining section has, at least in sections, an internal thread. The second joining section has, at least in sections, an external thread. The internal thread and the external thread engage one another and fasten the connection piece to the contact element. As a result, a quickly releasable connection between the connection piece and contact element can be provided.

In a further embodiment, the connection piece has an inlet. On the inside of the tubular section, a first channel section is guided to a tip of the tubular section. The first channel section is connected to the inlet in a fluidic manner.

In a further embodiment, the recess has a recess base. The recess base is arranged offset from the tip. The first channel section opens at the tip opposite the recess base.

In a further embodiment, the connection piece comprises a second channel section. The second channel section is arranged adjacent to the inlet. The first channel section and the second channel section are arranged offset from one another in the longitudinal direction and have a parallel orientation.

In a further embodiment, the connection piece has a third channel section. The third channel section connects the first channel section to the second channel section in a fluidic manner. The third channel section is inclined, preferably obliquely inclined, relative to the first channel section and/or the second channel section.

In a further embodiment, the connection piece has a fourth channel section. The fourth channel section is arranged overlapping the first channel section in the longitudinal direction. An opening of the fourth channel section in the recess is arranged offset from the tip of the tubular section in the longitudinal direction.

In a further embodiment, the fourth channel section has a ring-shaped configuration and is arranged on the periphery of the tubular section. In this way, local overheating of the contact element is avoided.

In a further embodiment, the connection piece has a fifth channel section. The fifth channel section is connected to the outlet. The fifth channel section is connected to the fourth channel section in a fluidic manner. The fifth channel section is arranged overlapping the second channel section in the longitudinal direction and laterally offset from the second channel section.

In a further embodiment, the cooling unit has a connection tube. The connection tube connects the first heat exchanger section to the second heat exchanger section in a fluidic manner. The connection tube electrically insulates the contact element from the heat sink.

In a further embodiment, the cooling unit has a first connection tube and a second connection tube, wherein the first connection tube connects the inlet of the connection piece to an outlet of the heat sink and is configured to guide the heat transfer medium from the outlet of the heat sink to the inlet of the connection piece, wherein the second connection tube connects the outlet of the connection piece to an inlet of the heat sink and is configured to guide the heat transfer medium from the outlet of the connection piece to the inlet of the heat sink.

In a further embodiment, the heat sink has at least one passive cooling element. Additionally or alternatively, the heat sink is mechanically coupled to the contact element.

In a further embodiment, the contact device has a contact housing, wherein the contact housing has a duct and at least one receptacle, wherein the duct opens in the receptacle. The contact element reaches through the duct. The first heat exchanger section is arranged, at least in sections, in the receptacle.

In a further embodiment, the heat transfer medium has dielectric properties. Preferably, the heat transfer medium has at least one of the following materials: water, preferably deionised water, perfluorinated carbon, hydrocarbon chain, long-chain hydrocarbon, synthetic oil, transformer oil, polyalphaolefin, ester oil.

The invention will be explained in more detail hereafter with reference to figures. In the drawings:
Figure 1 shows a perspective depiction of an arrangement;
Figure 2 shows a sectional view along a cutting plane A-A, shown in Figure 1, through a contact device of the arrangement shown in Figure 1;
Figure 3 shows a perspective depiction of subcomponents of the arrangement shown in Figure 1;
Figure 4 shows a sectional view along a cutting plane B-B, shown in Figure 3, through a contact element, shown in Figure 3, of a contact device;
Figure 5 shows a sectional view along the cutting plane B-B, shown in Figure 3, through a connection piece of the contact device;
Figures 6 and 7 show perspective views of the connection piece shown in Figure 5;
Figure 8 shows a sectional view along the cutting plane B-B, shown in Figure 3, through the subcomponents of the arrangement which are shown in Figure 3;
Figure 9 shows a sectional view along a cutting plane C-C, shown in Figure 1, through a cooling plane of a heat sink of the arrangement

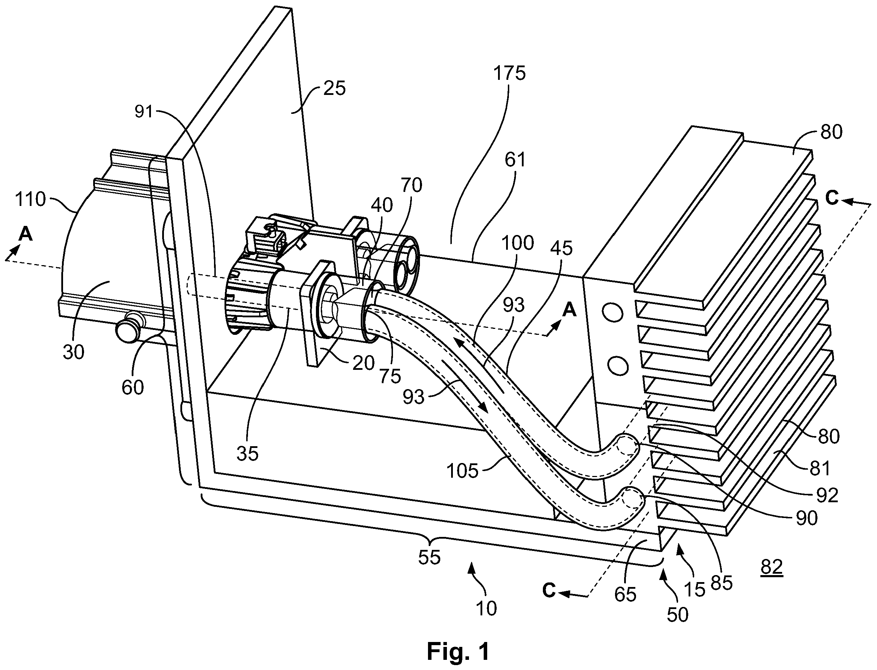

Figure 1 shows a perspective depiction of an arrangement 10. The arrangement 10 comprises a contact device 15, an electrical terminal 20 and a housing 25.

The contact device 15 has a contact housing 30, at least one contact element 35, a connection piece 40, a cooling unit 45. The cooling unit 45 has a heat sink 50.

In the embodiment, the contact device 15 is configured to be bipolar, for example, and has two contact elements 35 which are arranged in the common contact housing 30. By way of example, for every contact element 35 there is respectively provided a cooling unit 45. The contact device 15 can also be configured differently and, for example, a different number of contact elements 35 can be supplied and/or several contact elements 35 can be assigned to the cooling unit 45.

The housing 25 preferably has at least one first housing section 55 and one second housing section 60. The first housing section 55 is connected to the second housing section 60 at one solid end. Preferably, the first housing section 55 is arranged at right angles to the second housing section 60. The heat sink 50 is arranged adjacent to a free end 65 of the first housing section 55. The contact housing 30 is attached to the second housing section 60 in a central position, for example.

The electrical terminal 20 is configured as a bus bar, for example. Alternatively to the bus bar 20, the electrical terminal 20 can also have a cable lug.

The bus bar 20 is arranged running parallel to the second housing section 60. The bus bar 20 is arranged between the contact element 35 and the heat sink 50. The housing 25 preferably has an electrically insulating material and/or a dielectric material. The housing 25 can also have, at least in sections, an electrically conductive material. As a result, the housing 25 may provide a shielding function.

Furthermore, a control apparatus 61, which is electrically connected to the bus bar 20 and which is, for example, mechanically attached to the first housing section 55, can be provided between the first housing section 55 and the bus bar 20 (symbolically represented in Figure 1).

The contact element 35 is attached to the contact housing 30. The contact housing 30 has, like the housing 25, an electrically insulating material. The contact element 35 is further electrically coupled to the bus bar 20.

The connection piece 40 is arranged on the contact element 35. The connection piece 40 has a first inlet 70 and a first outlet 75. The heat sink 50 has a cooling element 80 with a second inlet 85 and a second outlet 90, for example. The cooling element 80 is configured as a passive cooling element 80, such that no additional fan device is provided.

The cooling element 80 has at least one cooling fin 81 on a side which faces away from the bus bar 20 and which faces the surrounding environment 82. The cooling fin 81 is arranged running parallel to the bus bar 20, for example. The cooling fin 81 can also be orientated differently or the cooling fin 81 can be omitted.

The cooling unit 45 also has, for example, a first heat exchanger section 91, a second heat exchanger section 92, a heat transfer medium 93, a first connection tube 100 and a second connection tube 105.

The heat transfer medium 93 is, irrespective of its phase state, electrically insulated and/or dielectric. Preferably, the heat transfer medium 93 has at least one of the following materials: water, preferably deionised water, perfluorinated carbon, hydrocarbon chain, long-chain hydrocarbon, synthetic oil, transformer oil, polyalphaolefin, ester oil.

Inside the cooling unit 45, the heat transfer medium 93 flows in a circuit. Preferably, the cooling unit 45 is completely filled with the heat transfer medium 93. The first heat exchanger section 91 is arranged in the contact element 35 between the first inlet 70 of the connection piece 40 and the first outlet 75 of the connection piece 40 in the direction of flow of the heat transfer medium 93. The second heat exchanger section 92 is arranged between the second inlet 85 of the cooling element 80 and the second outlet 90 of the cooling element 80 in the direction of flow. The first connection tube 100 connects the first inlet 70 of the connection piece 40 to the second outlet 90 of the cooling element 80 in a fluidic manner. The first connection tube 100 is in this case arranged downstream of the first outlet 75 of the connection piece 40. The second connection tube 105 connects the first outlet 75 of the connection piece 40 to the second inlet 85 of the cooling element 80 in a fluidic manner. The second connection tube 105 is in this case arranged downstream of the first outlet 75 of the connection piece 40.

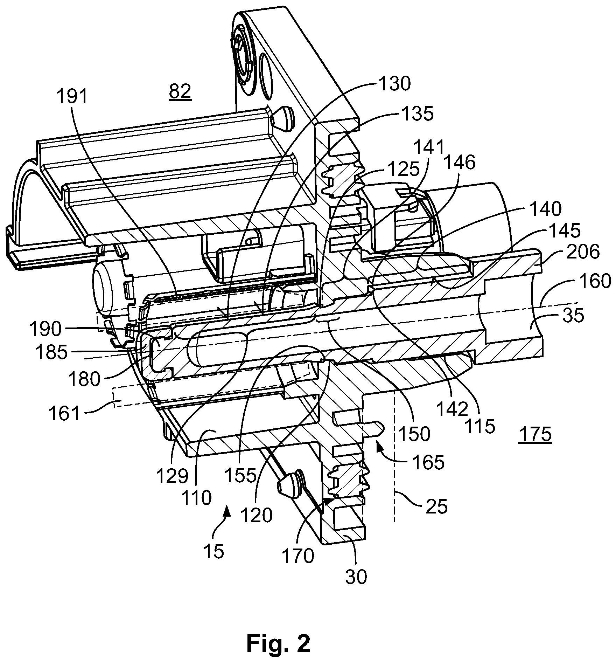

Figure 2 shows a sectional view along a cutting plane A-A, shown in Figure 1, through the contact device 15.

The contact housing 30 has a first receptacle 110 and a second receptacle 115. The first receptacle 110 is arranged on a side of the contact housing 30 which faces away from the bus bar 20. The second receptacle 115 is arranged on a side of the contact housing 30 which faces the bus bar 20. The first receptacle 110 is connected to the second receptacle 115 by means of a passage opening 120. Furthermore, a catching means 125 can be provided on the passage opening 120.

The contact element 35 has a contact section 129, an attachment section 140 and an anti-rotation device 141. The contact section 129 has a contact surface 135 on an outer peripheral surface 130. The contact surface 135 has a cylindrical configuration. The contact section 129 can also be configured as a socket contact.

The anti-rotation device 141 is arranged between the attachment section 140 and the contact surface 135 and prevents the contact element 35 from rotating in the receptacle 110, 115. It is particularly advantageous here if at least one offset 142 is provided between the attachment section 140 and the anti-rotation device 141 or on the attachment section 140.

The second receptacle 115 has a receiving contour 145 which is configured corresponding to the attachment section 140. The receiving contour 145 and the attachment section 140 of the contact element 35 have a cylindrical configuration, for example. In the embodiment the receiving contour 145 has a further offset 146, for example, which is assigned to the offset 142 of the contact element 35.

When the contact element 35 is in the mounted state, the attachment section 140 is arranged in the second receptacle 115. The offset 142 abuts against the further offset 146 of the receiving contour 145 and secures an axial position of the contact element 35 along a longitudinal axis 160. Furthermore, a further insertion of the contact element 35 into the second receptacle 115 is prevented by the offset 142 abutting against the further offset 146.

The contact surface 135 projects into the first receptacle 110. The contact surface 135 serves to bring the contact element 35 into electrical contact with a further contact device 161 (illustrated schematically with dashed lines) which is configured as a socket contact, for example.

The catching means 125 serves to fix a position of the contact element 35 at the contact housing 30 in the longitudinal direction. For this purpose, in the embodiment the contact element 35 has a constriction 150 between the contact surface 135 and the anti-rotation device 141, for example. Furthermore, a catching lug 155 is provided on the passage opening 120, which engages in the constriction 150 on the control element and prevents the withdrawal of the contact element 35 out of the second receptacle 115.

In order to ensure that the further contact device 161 encompasses the contact section 129, in the embodiment the first receptacle 110, for example, is configured wider than the second receptacle 115 in the direction transverse to the longitudinal axis 160 of the contact element 35. The design of the receptacle 110, 115 can also be different depending on the structural design of the contact element 35.

Furthermore, the contact element 35 can comprise an insulating cap 185 on a first longitudinal end 180, which is connected to the contact element 35 by means of a catching connection 190, for example. The insulating cap 185 can also be omitted.

Furthermore, the contact device 15 can have a shielding element 191, which is arranged in the first receptacle 110 and which is connected to the contact housing 30. The shielding element 191 encompasses the contact section 129 of the contact element 35. The shielding element 191 is arranged at a distance from the contact element 35.

The contact housing 30 has a retaining means 165 on a side which faces the housing 25. The retaining means 165 fastens the contact housing 30 to the second housing section 60. Furthermore, a sealing means 170 can be provided on the contact housing 30, in order to avoid an entry of liquids in a space 175 which is delimited by the housing 25 and the heat sink 50.

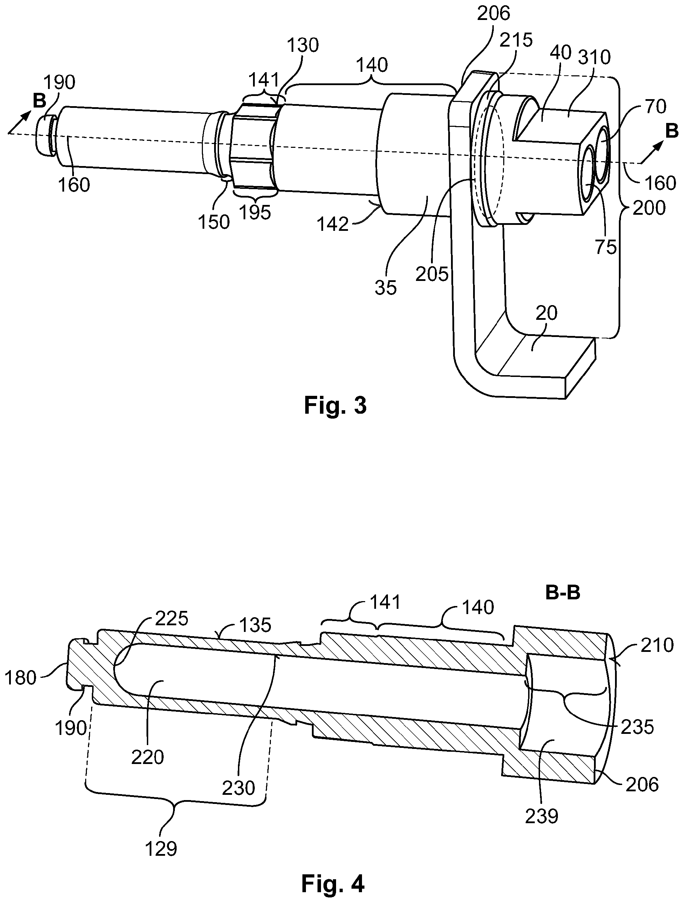

Figure 3 shows a perspective depiction of subcomponents of the arrangement 10 shown in Figure 1.

The anti-rotation device 141 can have a polygonal design on the outer peripheral surface 130 in a subregion 195. The second receptacle 115 is configured corresponding, in sections, to the subregion 195. This has the advantage that a rotation of the contact element 35 in the second receptacle 115 is reliably avoided.

The bus bar 20 has a bus bar joining section 200. The bus bar joining section 200 is orientated perpendicular to the longitudinal axis 160 of the contact element 35, for example. The bus bar joining section 200 has a further passage opening 205. The contact element 35 abuts against the bus bar joining section 200 with an end face 210 which is arranged on a second longitudinal end 206 opposite the first longitudinal end 180.

A ring element 215, for example, is provided on a side of the bus bar joining section 200 which is opposite the contact element 35. The ring element 215 can be configured as a washer.

The connection piece 40 reaches through the further passage opening 205 and attaches the contact element 35 and the ring element 206 onto respectively opposite sides of the bus bar joining section 200.

Figure 4 shows a sectional view along a cutting plane B-B, shown in Figure 3, through the contact element 35 shown in Figure 3.

The contact element 35 has a recess 220 which extends in the longitudinal direction parallel to the longitudinal axis 160 of the contact element 35. The recess 220 has a recess base 225 and a recess side surface 230 at the periphery. The recess 220 is configured as a bore, for example, and is open towards the second longitudinal end 206 of the contact element 35. The contact element 35 has a first joining section 235 axially between the second longitudinal end 206 and the recess 220. The recess 220 opens at the joining section 235. Furthermore, the recess 220 is arranged radially inside the contact surface 135.

The first joining section 235 has an internal thread 239 on the inner peripheral surface. Relative to the longitudinal axis 160, the first joining section 235 is configured radially wider than the recess 220.

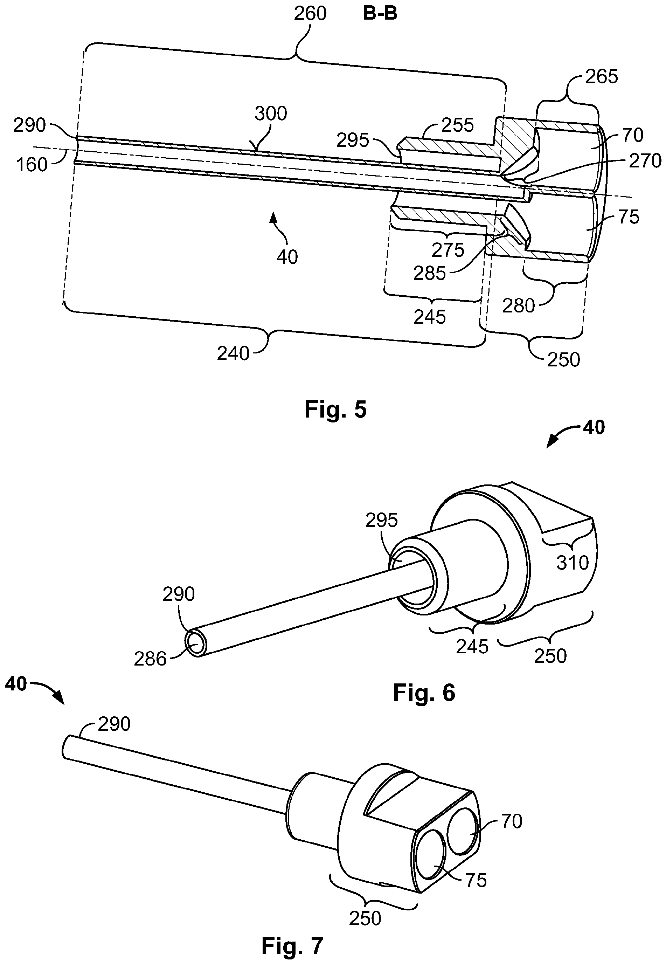

Figure 5 shows a sectional view along the cutting plane B-B, shown in Figure 3, through the connection piece 40.

The connection piece 40 has a tubular section 240, a second joining section 245 as well as a third joining section 250. The tubular section 240 is connected to the third joining section 250. The second joining section 245 is arranged radially outwardly adjacent to the third joining section 250 on a side which faces the tubular section 240.

The second joining section 245 has an external thread 255 on an outer peripheral surface. The external thread 255 is configured corresponding to the internal thread 239. In the mounted state of the connection piece 40 on the contact element 35, the second joining section 245 is screwed into the internal thread 239 by means of the external thread 255 and reliably secures the abutment of the end face 210 against the bus bar joining section 200.

The tubular section 240 is arranged in the recess 220. The tubular section 240 is configured running in a straight line. The tubular section 240 can also be curved. The tubular section 240 delimits on the inside a first channel section 260 of the connection piece 40.

Furthermore, the connection piece 40 has a second channel section 265, a third channel section 270, a fourth channel section 275, a fifth channel section 280 and a sixth channel section 285. The number of channel sections 260, 265, 270, 275, 280, 285 in the embodiment is by way of example. Naturally, a different number of channel sections 260, 265, 270, 275, 280, 285 can also be supplied.

The second channel section 265 is arranged adjacent to the first inlet 70 of the connection piece 40. The second channel section 280 can have a cylindrical configuration. While the first channel section 260 is arranged centrally relative to the longitudinal axis 160, the second channel section 265 is arranged offset off-centre from the longitudinal axis 160 and from the first channel section 260. The first channel section 260 and the second channel section 265 have a parallel orientation and are arranged offset in the axial direction. An attachment means can be provided on the second channel section 265 in order to connect the first connection tube 100 to the second channel section 265 in a fluid-tight manner.

The third channel section 270 is arranged between the first channel section 260 and the second channel section 265. The third channel section 270 is arranged running obliquely from radially outwards relative to the longitudinal axis 160 to radially inwards to the first channel section 260 and the second channel section 265. The third channel section 270 connects the second channel section 265 and thus the first inlet 70 of the connection piece 40 to the first channel section 260 in a fluidic manner. The third channel section 270 can also be omitted, for example, or the third channel section 270 can be arranged perpendicularly to the first channel section 260 and/or to the second channel section 265.

The fourth channel section 275 has a ring-shaped configuration. The fourth channel section 275 is arranged radially on the outside of the tubular section 240. The fourth channel section 275 opens at an opening 295 in the recess 220. The fourth channel section 275 and the first channel section 260 are arranged axially overlapping in the longitudinal direction. An axial overlapping is understood to mean that two components, in the embodiment the first channel section 260 and the fourth channel section 275, for example, are projected in a projection plane in which the longitudinal axis 160 is arranged, wherein the components in the projection plane cover one another.

The fifth channel section 280 is arranged adjacent to the first outlet 75 of the connection piece 40. The fifth channel section 280 is arranged off-centre relative to the longitudinal axis 160. The fifth channel section 280 can have a cylindrical configuration. Furthermore, the fifth channel section 280 is arranged axially overlapping the second channel section 265 and laterally offset from the second channel section 265. The fifth channel section 280 is arranged running parallel to the second channel section 265.

Furthermore, a further attachment means can be provided on the fifth channel section 280 in order to connect the second connection tube 105 to the fifth channel section 280 in a fluid-tight manner.

The sixth channel section 285 is provided between the fifth channel section 280 and the fourth channel section 275. The sixth channel section 285 connects the fifth channel section 280 to the fourth channel section 275 in a fluidic manner. The sixth channel section 285 is arranged running obliquely to the fifth channel section 280.

Figures 6 and 7 show perspective views of the connection piece 40.

The connection piece 40 can additionally have a tool profile 310 on the third joining section 250. A torque from a tool can be introduced into the connection piece 40 by means of the tool profile 310, in order to screw the second joining section 245 into the first joining section 235 and to supply a clamping force in order to press the contact element 35, at the end face on the second longitudinal end 206, against the bus bar joining section 200. The torque during screwing-in is supported at the rear on the contact housing 30 via the anti-rotation device 141.

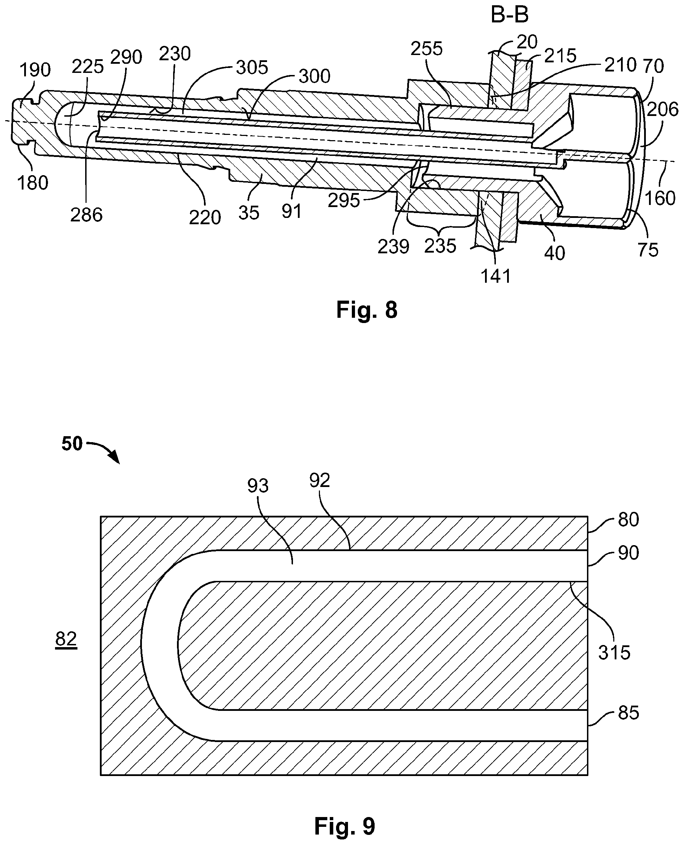

Figure 8 shows a sectional view along a cutting plane B-B, shown in Figure 3, through the subcomponents of the arrangement 10 which are shown in Figure 3.

A further opening 286 of the first channel section 260 opens at a tip 290 of the tubular section 240 opposite the recess base 225 in the recess 220. The opening 295 is arranged offset from the opening 286 of the first channel section 260 in the axial direction relative to the longitudinal axis 260.

The tubular section 240 has an outer peripheral surface 300. The outer peripheral surface 300 is arranged at a distance from the recess side surface 230. The recess side surface 230 together with the recess base 225 and the outer peripheral surface 300 of the tubular section 240 between the further opening 286 and opening 295 delimit a first heat exchanger section 91. The first heat exchanger section 91 is connected to the first outlet 75 of the connection piece 40 via the fourth to sixth channel sections 275, 280, 285 in a fluidic manner.

Furthermore, the first heat exchanger section 91 is connected to the first inlet 70 of the connection piece 40 in a fluidic manner on the inlet side via the first to third channel sections 260, 265, 270.

Figure 9 shows a sectional view along a cutting plane C-C, shown in Figure 1, through the cooling element 80 of the heat sink 50.

A second heat exchanger section 92 is arranged in the cooling element 80. The second heat exchanger section 92 is guided within the cooling element 80 in a channel shape, for example a U-shape in the embodiment. Other designs of the second heat exchanger section 92 are also conceivable. The second heat exchanger section 92 is connected to the second inlet 85 on the inlet side and to the second outlet 90 of the cooling element 80 on the outlet side in a fluidic manner.

When the arrangement 10 is in operation, a further contact device 161 is joined to the contact device 15. The arrangement 10 serves to transfer electrical energy with a high current between the further contact device 161 and the bus bar 20. In the process, the contact element 35 heats up, in particular in the region of the electrical contact between the further contact device 161 at the contact surface 135. The heat introduced into the contact element 35 is thus carried off from the contact element 35 in that cold heat transfer medium 93 is introduced into the second channel section 265 via the first inlet 70 of the connection piece 40. The second channel section 265 guides the cold heat transfer medium 93 to the tip 290 of the tubular section 240 via the third channel section 270 and the first channel section 260. The heat transfer medium 93 enters the first heat exchanger section 91 at the tip 290. In the first heat exchanger section 91, the heat transfer medium 93 is guided within the recess 220 between the outer peripheral surface 300 of the tubular section 240, towards the further opening 295 of the fourth channel section 275. When flowing along the recess base 225 and the recess side surface 230, the heat transfer medium 93 absorbs heat from the contact element 35 and heats up. The heated heat transfer medium 93 is carried off from the first heat exchanger section 91 via the further opening 295 and then enters the fourth channel section 275. The ring-shaped design of the fourth channel section 275 has the advantage that local overheating of the contact element 35 is avoided by a uniform flow of the heat transfer medium 93 within the recess 220.

The heated heat transfer medium 93 is guided from the fourth channel section 275 to the fifth channel section 280 via the sixth channel section 285. The heated heat transfer medium 93 enters the second connection tube 105 at the fifth channel section 280 via the first outlet 75 of the connection piece 40. The second connection tube 105 guides the heated heat transfer medium 93 to the second inlet 85 of the cooling element 80. The heated heat transfer medium 93 enters the cooling element 80 at the second inlet 85 of the cooling element 80. In the second heat exchanger section 92, the heated heat transfer medium 93 gives off heat to the cooling element 80. The cooling element 80 gives the heat off to an environment 82 surrounding the arrangement 10 via cooling fins 81. The cooled cold heat transfer medium 93 exits from the second heat exchanger section 92 at the second outlet 90 of the cooling element 80 and is guided to the first inlet 70 of the connection piece 40 via the first connection tube 100. The heat transfer medium 93 thus flows in a circuit.

Additionally, a conveying device (not illustrated in the figures) can be provided in order to force the flowing of the heat transfer medium 93 in the circuit between the first heat exchanger section 91 and the second heat exchanger section 92 for carrying heat off from the contact element 35. This design has the advantage that a particularly high heat input can be carried off from the contact element 35. The hoisting device can be arranged upstream or downstream of the first heat exchanger section 91.

Additionally or alternatively, it is also possible that the heat sink is arranged higher than the first heat exchanger section 91, such that the heat transfer medium flows in a circuit between the first heat exchanger section 91 and the second heat exchanger section 92 due to differences in density between the heated heat transfer medium 93 and the cold heat transfer medium.

It is of particular advantage here if the second outlet 90 is arranged below the second inlet 85.

Using dielectric materials for the connection tube 100, 105 as well as for the heat transfer medium 93 ensures that the heat sink 50 is not energised.

If a cooling unit 45 is provided for every contact element 35, it is an advantage if the cooling elements 80 are arranged in a stack-like manner. The cooling units 45 can be configured identically.

Cooled heat transfer medium 93 can be directly guided to the warmest region within the contact surface 135 of the contact element 35 by means of the above-described design of the arrangement 10, such that an overheating of the contact element 35 is reliably avoided even when high currents are to be transferred. In particular, a particularly high carry-off of heat from the contact element 35 can be ensured if the contact element 35 has copper as the material. Furthermore, the design of the cooling element 80 described above ensures that no additional electrical insulation has to be supplied to the heat sink 50 and the contact element 35.

The arrangement 10 is thus particularly suitable for plug-in hybrid vehicles and/or for electrical motor vehicles.

### Reference Numbers

- 10: Arrangement
- 15: Contact device
- 20: Electrical terminal, bus bar, cable lug
- 25: Housing
- 30: Contact housing
- 35: Contact element
- 40: Connection piece
- 45: Cooling unit
- 50: Heat sink
- 55: First housing section
- 60: Second housing section
- 61: Control apparatus
- 65: Free end of the first housing section
- 70: First inlet (of the connection piece)
- 75: First outlet (of the connection piece)
- 80: Cooling element
- 81: Cooling fin
- 82: Surrounding environment
- 85: Second inlet (of the cooling element)
- 90: Second outlet (of the cooling element)
- 91: First heat exchanger section
- 92: Second heat exchanger section
- 93: Heat transfer medium
- 100: First connection tube
- 105: Second connection tube
- 110: First receptacle
- 115: Second receptacle
- 120: Passage opening
- 125: Catching means
- 129: Contact section
- 130: Outer peripheral surface (of the contact section)
- 135: Contact surface
- 140: Attachment section
- 141: Anti-rotation device
- 142: Offset
- 145: Receiving contour
- 146: Further offset
- 150: Constriction
- 155: Catching lug
- 160: Longitudinal axis
- 161: Further contact device
- 165: Retaining means
- 170: Sealing means
- 175: Space
- 180: First longitudinal end
- 185: Insulating cap
- 190: Catching connection
- 195: Subregion
- 200: Bus bar joining section
- 205: Further passage opening
- 206: Second longitudinal end
- 210: Further end face
- 215: Ring element
- 220: Recess
- 225: Recess base
- 230: Recess side surface
- 235: First joining section
- 239: Internal thread
- 240: Tubular section
- 245: Second joining section
- 250: Third joining section
- 255: External thread
- 260: First channel section
- 265: Second channel section
- 270: Third channel section
- 275: Fourth channel section
- 280: Fifth channel section
- 285: Sixth channel section
- 286: Further opening
- 290: Tip
- 295: Opening
- 300: Outer peripheral surface of the tubular section
- 310: Tool profile

## Claims

1. A contact device (15) for high-current transfer,
- comprising a contact element (35) and a cooling unit (45),
- the cooling unit (45) comprising a heat sink (50), a heat transfer medium (93), a first heat exchanger section (91) and a second heat exchanger section (92),
- wherein the first heat exchanger section (91) is connected to the second heat exchanger section (92) in a fluidic manner,
- wherein the heat sink (50) is arranged at a distance from the contact element (35),
- wherein the heat sink (50) is connected to the second heat exchanger section (92),
- wherein the first heat exchanger section (91) is arranged in the contact element (35),
- wherein the heat transfer medium (93) circulates in a circuit between the first heat exchanger section (91) and the second heat exchanger section (92),
- wherein the heat sink (50) is electrically insulated from the contact element (35),
- wherein the contact element (35) extends in a longitudinal direction,
- wherein the contact element (35) has, on an outer peripheral surface (130), a contact surface (135) for electrical contacting,
- wherein the contact element (35) has a recess (220) which extends, at least in sections, in the longitudinal direction,
- wherein the first heat exchanger section (91) is arranged in the recess (220),
- wherein a first joining section (235) is supplied on a longitudinal end (206) of the contact element (35),
- wherein a connection piece (40) is supplied,
- wherein the connection piece (40) comprises a tubular section (240) and a second joining section (245) which is connected to the tubular section (240),
- wherein the tubular section (240) is arranged in the recess (220),
- wherein the second joining section (245) is connected to the first joining section (235) in a fluid-tight manner,
- wherein the connection piece (40) has an outlet (75),
- wherein the tubular section (240) has an outer peripheral surface (300),
- wherein the recess (220) and the outer peripheral surface (300) of the tubular section (240) delimit the first heat exchanger section (91),
- wherein the first heat exchanger section (91) is connected to the outlet (75) of the connection piece (40) in a fluidic manner,
- **characterized in that**
- the tubular section (240) is arranged running centrally in the recess (220),
- wherein the outer peripheral surface (300) is arranged at a distance from a recess side surface (230) of the recess (220).

2. The contact device (15) according to Claim 1,
- wherein the first joining section (235) has, at least in sections, an internal thread (239),
- wherein the second joining section (245) has, at least in sections, an external thread (255),
- wherein the internal thread (239) and the external thread (255) engage one another and fasten the connection piece (40) to the contact element (35).

3. The contact device (15) according to any one of the preceding claims,
- wherein the connection piece (40) has an inlet (70),
- wherein, on the inside of the tubular section (240), a first channel section (260) is guided to a tip (290) of the tubular section (240)
- wherein the first channel section (260) is connected to the inlet (70) in a fluidic manner.

4. The contact device (15) according to Claim 3,
- wherein the recess (220) comprises a recess base (225)
- wherein the recess base (225) is arranged offset from the tip (290),
- wherein the first channel section (260) opens at the tip (290) opposite the recess base (225).

5. The contact device (15) according to Claim 3 or 4,
- wherein the connection piece (40) comprises a second channel section (265),
- wherein the second channel section (265) is arranged adjacent to the inlet (70),
- wherein the first channel section (260) and the second channel section (265) are arranged offset from one another in the longitudinal direction and have a parallel orientation.

6. The contact device (15) according to Claim 5,
- wherein the connection piece (40) comprises a third channel section (270),
- wherein the third channel section (270) connects the first channel section (260) to the second channel section (265) in a fluidic manner,
- wherein the third channel section (270) is arranged inclined, preferably obliquely inclined, relative to the first channel section (260) and/or the second channel section (265).

7. The contact device (15) according to any one of Claims 3 to 6,
- wherein the connection piece (40) comprises a fourth channel section (275),
- wherein the fourth channel section (275) is arranged overlapping the first channel section (260) in the longitudinal direction,
- wherein an opening (295) of the fourth channel section (275) in the recess (220) is arranged offset from the tip (290) of the tubular section (240) in the longitudinal direction.

8. The contact device (15) according to Claim 7,
- wherein the fourth channel section (275) has a ring-shaped configuration and is arranged on the periphery of the tubular section (240).

9. The contact device (15) according to Claim 7 or 8,
- wherein the connection piece (40) comprises a fifth channel section (280),
- wherein the fifth channel section (280) is connected to the outlet (75),
- wherein the fifth channel section (280) is connected to the fourth channel section (275) in a fluidic manner,
- wherein the fifth channel section (280) is arranged overlapping the second channel section (265) in the longitudinal direction and laterally offset from the second channel section (265).

10. The contact device (15) according to any one of Claims 6 to 9,
- wherein the cooling unit (45) comprises a first connection tube (100) and a second connection tube (105),
- wherein the first connection tube (100) connects the inlet (70) of the connection piece (40) to an outlet (90) of the heat sink (50) and is configured to guide the heat transfer medium (93) from the outlet (90) of the heat sink (50) to the inlet (70) of the connection piece (40),
- wherein the second connection tube (105) connects the outlet (75) of the connection piece (40) to an inlet (85) of the heat sink (50) and is configured to guide the heat transfer medium (93) from the outlet (75) of the connection piece (40) to the inlet (85) of the heat sink (50).

11. The contact device (15) according to any one of the preceding claims,
- wherein the heat sink (50) has at least one passive cooling element (80),
- and/or
- wherein the heat sink (50) is mechanically connected to the contact element (35).

12. The contact device (15) according to any one of the preceding claims,
- comprising a contact housing (30),
- wherein the contact housing (30) has a duct and at least one receptacle (110, 115),
- wherein the duct opens in the receptacle (110, 115),
- wherein the contact element (35) reaches through the duct,
- wherein the first heat exchanger section (91) is arranged, at least in sections, in the receptacle (110, 115).

13. The contact device (15) according to any one of the preceding claims,
- wherein the heat transfer medium (93) has dielectric properties,
- wherein preferably the heat transfer medium (93) has at least one of the following materials:
- water, preferably deionised water,
- perfluorinated carbon,
- hydrocarbon chain,
- long-chain hydrocarbon,
- synthetic oil,
- transformer oil,
- polyalphaolefin,
- ester oil.

## Patentansprüche

1. Kontakteinrichtung (15) zur Hochstromübertragung,
- aufweisend ein Kontaktelement (35)und eine Kühleinheit (45),
- wobei die Kühleinheit (45), eine Wärmesenke (50) ein Wärmeträgermedium (93), einen ersten Wärmetauscherabschnitt (91) und einen zweiten Wärmetauscherabschnitt (92) umfasst,
- wobei der erste Wärmetauscherabschnitt (91) fluidisch mit dem zweiten Wärmetauscherabschnitt (92) verbunden ist,
- wobei die Wärmesenke (50) beabstandet zu dem Kontaktelement (35) angeordnet ist,
- wobei die Wärmesenke (50) mit dem zweiten Wärmetauscherabschnitt (92) verbunden ist,
- wobei der erste Wärmetauscherabschnitt (91) in dem Kontaktelement (35) angeordnet ist,
- wobei das Wärmeträgermedium (93) zwischen dem ersten Wärmetauscherabschnitt (91) und dem zweiten Wärmetauscherabschnitt (92) im Kreislauf zirkuliert,
- wobei die Wärmesenke (50) elektrisch vom Kontaktelement (35) isoliert ist,
- wobei das Kontaktelement (35) sich in Längsrichtung erstreckt,
- wobei das Kontaktelement (35) an einer äußeren Umfangsfläche (130) eine Kontaktfläche (135) zur elektrischen Kontaktierung aufweist,
- wobei das Kontaktelement (35) eine sich zumindest abschnittsweise in Längsrichtung erstreckende Aussparung (220) aufweist,
- wobei in der Aussparung (220) der erste Wärmetauscherabschnitt (91) angeordnet ist,
- wobei an einem Längsende (206) des Kontaktelements (35) ein erster Anschlussabschnitt (235) vorgesehen ist,
- wobei ein Verbindungsstück (40) vorgesehen ist,
- wobei das Verbindungsstück (40) einen Rohrabschnitt (240) und einen mit dem Rohrabschnitt (240) verbundenen zweiten Anschlussabschnitt (245) umfasst,
- wobei der Rohrabschnitt (240) in der Aussparung (220) angeordnet ist,
- wobei der zweite Anschlussabschnitt (245) mit dem ersten Anschlussabschnitt (235) fluiddicht verbunden ist,
- wobei das Verbindungsstück (40) einen Ausgang (75) aufweist,
- wobei der Rohrabschnitt (240) eine äußere Umfangsfläche (300) aufweist,
- wobei die Aussparung (220) und die äußere Umfangsfläche (300) des Rohrabschnitts (240) den ersten Wärmetauscherabschnitt (91) begrenzen,
- wobei der erste Wärmetauscherabschnitt (91) mit dem Ausgang (75) des Verbindungsstücks (40) fluidisch verbunden ist,
**dadurch gekennzeichnet, dass**
- der Rohrabschnitt (240) zentriert in der Aussparung (220) verlaufend angeordnet ist,
- wobei die äußere Umfangsfläche (300) beabstandet zu der Aussparungsseitenfläche (230) angeordnet ist.

2. Kontakteinrichtung (15) nach Anspruch 1,
- wobei der erste Anschlussabschnitt (235) zumindest abschnittsweise ein Innengewinde (239) aufweist,
- wobei der zweite Anschlussabschnitt (245) zumindest abschnittsweise ein Außengewinde (255) aufweist,
- wobei das Innengewinde (239) und das Außengewinde (255) ineinander eingreifen und das Verbindungsstück (40) am Kontaktelement (35) fixieren.

3. Kontakteinrichtung (15) nach einem der vorhergehenden Ansprüche,
- wobei das Verbindungsstück (40) einen Eingang (70) aufweist,
- wobei in dem Rohrabschnitt (240) innenseitig ein erster Kanalabschnitt (260) zu einer Spitze (290) des Rohrabschnitts (240) geführt ist,
- wobei der erste Kanalabschnitt (260) mit dem Eingang (70) fluidisch verbunden ist.

4. Kontakteinrichtung (15) nach Anspruch 3,
- wobei die Aussparung (220) einen Aussparungsgrund (225) umfasst,
- wobei der Aussparungsgrund (225) versetzt zu der Spitze (290) angeordnet ist,
- wobei der erste Kanalabschnitt (260) gegenüberliegend zum Aussparungsgrund (225) an der Spitze (290) mündet.

5. Kontakteinrichtung (15) nach Anspruch 3 oder 4,
- wobei das Verbindungsstück (40) einen zweiten Kanalabschnitt (265) umfasst,
- wobei der zweite Kanalabschnitt (265) angrenzend an den Eingang (70) angeordnet ist,
- wobei der erste Kanalabschnitt (260) und der zweite Kanalabschnitt (265) in Längsrichtung versetzt zueinander angeordnet sind und eine parallele Ausrichtung aufweisen.

6. Kontakteinrichtung (15) nach Anspruch 5,
- wobei das Verbindungsstück (40) einen dritten Kanalabschnitt (270) umfasst,
- wobei der dritte Kanalabschnitt (270) den ersten Kanalabschnitt (260) mit dem zweiten Kanalabschnitt (265) fluidisch verbindet,
- wobei der dritte Kanalabschnitt (270) geneigt, vorzugsweise schräg geneigt, zu dem ersten Kanalabschnitt (260) und/oder dem zweiten Kanalabschnitt (265) angeordnet ist.

7. Kontakteinrichtung (15) nach einem der Ansprüche 3 bis 6,
- wobei das Verbindungsstück (40) einen vierten Kanalabschnitt (275) umfasst,
- wobei der vierte Kanalabschnitt (275) in Längsrichtung überlappend zum ersten Kanalabschnitt (260) angeordnet ist,
- wobei eine Mündung (295) des vierten Kanalabschnitts (275) in der Aussparung (220) in Längsrichtung versetzt zu der Spitze (290) des Rohrabschnitts (240) angeordnet ist.

8. Kontakteinrichtung (15) nach Anspruch 7,
- wobei der vierte Kanalabschnitt (275) ringförmig ausgebildet ist und umfangsseitig des Rohrabschnitts (240) angeordnet ist.

9. Kontakteinrichtung (15) nach Anspruch 7 oder 8,
- wobei das Verbindungsstück (40) einen fünften Kanalabschnitt (280) umfasst,
- wobei der fünfte Kanalabschnitt (280) mit dem Ausgang (75) verbunden ist,
- wobei der fünfte Kanalabschnitt (280) fluidisch mit dem vierten Kanalabschnitt (275) verbunden ist,
- wobei der fünfte Kanalabschnitt (280) in Längsrichtung überlappend zu dem zweiten Kanalabschnitt (265) und seitlich versetzt zu dem zweiten Kanalabschnitt (265) angeordnet ist.

10. Kontakteinrichtung (15) nach einem der Ansprüche 6 bis 9,
- wobei die Kühleinheit (45) ein erstes Verbindungsrohr (100) und ein zweites Verbindungsrohr (105) umfasst,
- wobei das erste Verbindungsrohr (100) den Eingang (70) des Verbindungsstücks (40) mit einem Ausgang (90) der Wärmesenke (50) verbindet und ausgebildet ist, das Wärmeträgermedium (93) vom Ausgang (90) der Wärmesenke (50) zum Eingang (70) des Verbindungsstücks (40) zu führen,
- wobei das zweite Verbindungsrohr (105) den Ausgang (75) des Verbindungsstücks (40) mit einem Eingang (85)der Wärmesenke (50) verbindet und ausgebildet ist, das Wärmeträgermedium (93) vom Ausgang (75) des Verbindungsstücks (40) zum Eingang (85) der Wärmesenke (50) zu führen.

11. Kontakteinrichtung (15) nach einem der vorhergehenden Ansprüche,
- wobei die Wärmesenke (50) wenigstens ein passives Kühlelement (80) aufweist,
- und/oder
- wobei die Wärmesenke (50) mechanisch mit dem Kontaktelement (35) verbunden ist.

12. Kontakteinrichtung (15) nach einem der vorhergehenden Ansprüche,
- aufweisend ein Kontaktgehäuse (30),
- wobei das Kontaktgehäuse (30) eine Durchführung und wenigstens eine Aufnahme (110, 115) aufweist,
- wobei die Durchführung in der Aufnahme (110, 115) mündet,
- wobei das Kontaktelement (35) die Durchführung durchgreift,
- wobei der erste Wärmetauscherabschnitt (91) zumindest abschnittsweise in der Aufnahme (110, 115) angeordnet ist.

13. Kontakteinrichtung (15) nach einem der vorhergehenden Ansprüche,
- wobei das Wärmeträgermedium (93) dielektrische Eigenschaften aufweist,
- wobei vorzugsweise das Wärmeträgermedium (93) wenigstens einen der folgenden Werkstoffe aufweist:
- Wasser, vorzugsweise entionisiertes Wasser,
- perfluorierten Kohlenstoff,
- Kohlenwasserstoffkette,
- langkettige Kohlenwasserstoff,
- synthetisches Öl,
- Transformatorenöl,
- Polyalphaolefin,
- Esteröl.

## Revendications

1. Dispositif de contact (15) pour le transfert de courant élevé,
- comprenant un élément de contact (35) et une unité de refroidissement (45),
- l'unité de refroidissement (45) comprenant un dissipateur de chaleur (50), un milieu de transfert de chaleur (93), une première section d'échangeur de chaleur (91) et une deuxième section d'échangeur de chaleur (92),
- la première section d'échangeur de chaleur (91) étant reliée à la deuxième section d'échangeur de chaleur (92) d'une manière fluidique,
- le dissipateur de chaleur (50) étant agencé à une distance de l'élément de contact (35),
- le dissipateur de chaleur (50) étant relié à la deuxième section d'échangeur de chaleur (92),
- la première section d'échangeur de chaleur (91) étant agencée dans l'élément de contact (35),
- le milieu de transfert de chaleur (93) circulant dans un circuit entre la première section d'échangeur de chaleur (91) et la deuxième section d'échangeur de chaleur (92),
- le dissipateur de chaleur (50) étant isolé électriquement de l'élément de contact (35),
- l'élément de contact (35) s'étendant dans une direction longitudinale,
- l'élément de contact (35) ayant, sur une surface périphérique extérieure (130), une surface de contact (135) pour le contact électrique,
- l'élément de contact (35) ayant un évidement (220) qui s'étend, au moins par sections, dans la direction longitudinale,
- la première section d'échangeur de chaleur (91) étant agencée dans l'évidement (220),
- une première section de jonction (235) étant fournie sur une extrémité longitudinale (206) de l'élément de contact (35),
- une pièce de raccordement (40) étant fournie,
- la pièce de raccordement (40) comprenant une section tubulaire (240) et une deuxième section de jonction (245) qui est reliée à la section tubulaire (240),
- la section tubulaire (240) étant agencée dans l'évidement (220),
- la deuxième section de jonction (245) étant reliée à la première section de jonction (235) de manière étanche aux fluides,
- la pièce de raccordement (40) ayant une sortie (75),
- la section tubulaire (240) ayant une surface périphérique extérieure (300),
- l'évidement (220) et la surface périphérique extérieure (300) de la section tubulaire (240) délimitant la première section d'échangeur de chaleur (91),
- la première section d'échangeur de chaleur (91) étant reliée à la sortie (75) de la pièce de raccordement (40) d'une manière fluidique,
- **caractérisé en ce que**
- la section tubulaire (240) est agencée de manière à s'étendre au centre de l'évidement (220),
- la surface périphérique extérieure (300) étant agencée à une distance d'une surface latérale d'évidement (230) de l'évidement (220).

2. Dispositif de contact (15) selon la revendication 1,
- la première section de jonction (235) ayant, au moins par sections, un filetage intérieur (239),
- la deuxième section de jonction (245) ayant, au moins par sections, un filetage extérieur (255),
- le filetage intérieur (239) et le filetage extérieur (255) s'engageant l'un dans l'autre et fixant la pièce de raccordement (40) à l'élément de contact (35).

3. Dispositif de contact (15) selon l'une quelconque des revendications précédentes,
- la pièce de raccordement (40) ayant une entrée (70),
- sur le côté intérieur de la section tubulaire (240), une première section de canal (260) étant guidée vers une pointe (290) de la section tubulaire (240)
- la première section de canal (260) étant reliée à l'entrée (70) d'une manière fluidique.

4. Dispositif de contact (15) selon la revendication 3,
- l'évidement (220) comprenant une base d'évidement (225)
- la base d'évidement (225) étant agencée de manière décalée par rapport à la pointe (290),
- la première section de canal (260) s'ouvrant à la pointe (290) opposée à la base d'évidement (225).

5. Dispositif de contact (15) selon la revendication 3 ou 4,
- la pièce de raccordement (40) comprenant une deuxième section de canal (265),
- la deuxième section de canal (265) étant agencée de façon adjacente à l'entrée (70),
- la première section de canal (260) et la deuxième section de canal (265) étant agencées de manière décalée l'une par rapport à l'autre dans la direction longitudinale et ayant une orientation parallèle.

6. Dispositif de contact (15) selon la revendication 5,
- la pièce de raccordement (40) comprenant une troisième section de canal (270),
- la troisième section de canal (270) reliant la première section de canal (260) à la deuxième section de canal (265) d'une manière fluidique,
- la troisième section de canal (270) étant agencée de manière inclinée, de préférence obliquement, par rapport à la première section de canal (260) et/ou à la deuxième section de canal (265).

7. Dispositif de contact (15) selon l'une quelconque des revendications 3 à 6,
- la pièce de raccordement (40) comprenant une quatrième section de canal (275),
- la quatrième section de canal (275) étant agencée en chevauchant la première section de canal (260) dans la direction longitudinale,
- une ouverture (295) de la quatrième section de canal (275) dans l'évidement (220) étant agencée de manière décalée par rapport à la pointe (290) de la section tubulaire (240) dans la direction longitudinale.

8. Dispositif de contact (15) selon la revendication 7,
- la quatrième section de canal (275) ayant une configuration en forme d'anneau et étant agencée sur la périphérie de la section tubulaire (240).

9. Dispositif de contact (15) selon la revendication 7 ou 8,
- la pièce de raccordement (40) comprenant une cinquième section de canal (280),
- la cinquième section de canal (280) étant reliée à la sortie (75),
- la cinquième section de canal (280) étant reliée à la quatrième section de canal (275) d'une manière fluidique,
- la cinquième section de canal (280) étant agencée en chevauchant la deuxième section de canal (265) dans la direction longitudinale et décalée latéralement par rapport à la deuxième section de canal (265).

10. Dispositif de contact (15) selon l'une quelconque des revendications 6 à 9,
- l'unité de refroidissement (45) comprenant un premier tube de raccordement (100) et un second tube de raccordement (105),
- le premier tube de raccordement (100) reliant l'entrée (70) de la pièce de raccordement (40) à une sortie (90) du dissipateur de chaleur (50) et étant configuré pour guider le milieu de transfert de chaleur (93) de la sortie (90) du dissipateur de chaleur (50) à l'entrée (70) de la pièce de raccordement (40),
- le second tube de raccordement (105) reliant la sortie (75) de la pièce de raccordement (40) à une entrée (85) du dissipateur de chaleur (50) et étant configuré pour guider le milieu de transfert de chaleur (93) de la sortie (75) de la pièce de raccordement (40) à l'entrée (85) du dissipateur de chaleur (50).

11. Dispositif de contact (15) selon l'une quelconque des revendications précédentes,
- le dissipateur de chaleur (50) ayant au moins un élément de refroidissement passif (80),
- et/ou
- le dissipateur de chaleur (50) étant relié mécaniquement à l'élément de contact (35).

12. Dispositif de contact (15) selon l'une quelconque des revendications précédentes,
- comprenant un boîtier de contact (30),
- le boîtier de contact (30) ayant un conduit et au moins un réceptacle (110, 115),
- le conduit s'ouvrant dans le logement (110, 115), l'élément de contact (35) s'étendant à travers le conduit,
- la première section d'échangeur de chaleur (91) étant agencée, au moins par sections, dans le réceptacle (110, 115).

13. Dispositif de contact (15) selon l'une quelconque des revendications précédentes,
- le milieu de transfert de chaleur (93) ayant des propriétés diélectriques,
- de préférence le milieu de transfert de chaleur (93) ayant au moins l'un des matériaux suivants :
- de l'eau, de préférence de l'eau déionisée,
- du carbone perfluoré,
- une chaîne d'hydrocarbures,
- un hydrocarbure à longue chaîne,
- de l'huile synthétique,
- de l'huile de transformateur,
- une polyalphaoléfine,
- de l'huile d'ester.
